# EUROPEAN PATENT APPLICATION

(11) **EP 4 611 354 A1**
(43) Date of publication of application: **03.09.2025**
(21) Application number: 23898147.6
(22) Date of filing: 14.11.2023
(51) Int. Cl.: H04M 1/02, H05K 5/00, H05K 5/03

(54) **ELECTRONIC DEVICE COMPRISING DISPLAY MODULE ADHESIVE STRUCTURE**

(30) Priority: 30.11.2022 KR 20220164947; 20.12.2022 KR 20220179658
(71) Applicant: Samsung Electronics Co., Ltd., Suwon-si, Gyeonggi-do 16677 (KR)
(72) Inventor: HONG, Changrak, Suwon-si, Gyeonggi-do 16677 (KR); KIM, Seongjun, Suwon-si, Gyeonggi-do 16677 (KR); SONG, Seungwon, Suwon-si, Gyeonggi-do 16677 (KR); KIM, Jeongseob, Suwon-si, Gyeonggi-do 16677 (KR); OH, Chunghwan, Suwon-si, Gyeonggi-do 16677 (KR); JUN, Intae, Suwon-si, Gyeonggi-do 16677 (KR)
(74) Representative: Walaski, Jan Filip
(86) International application number: PCT/KR2023/018268
(87) International publication number: WO 2024/117615

(57) **Abstract**

An electronic device according to an embodiment of the present disclosure may comprise: a window layer of which at least a part is transparent; a display module disposed under the window layer; a housing including a front surface on which the display module is disposed, a rear surface opposite to the front surface, and a side surface surrounding a space between the front and the rear surface; a frame surrounding the side surface of the housing and the side surface of the window layer; a first conduit formed on at least one of a surface of the frame facing the housing and the side surface of the housing facing the frame, the first conduit extending from the rear surface of the electronic device to the front surface; and an adhesive material which is introduced into the first conduit to bond the side surface of the window layer to the housing and the frame.

## Description

### [Technical Field]

Various embodiments disclosed in this document relate to an electronic device including a display module adhesive structure.

### [Background Art]

A display module of an electronic device such as a smartphone includes a bezel, which is a peripheral edge area excluding a display unit where a screen is output. Recently, as the full screen trend continues, research is being conducted to minimize a bezel in order to maximize an area of a display unit occupied by a screen rather than increasing the size of an electronic device itself.

### [Disclosure of Invention]

### [Technical Problem]

A display module may be fixed to a housing of the electronic device through an adhesive material. The adhesive material may be positioned at an outer edge of the display module so as to avoid interference with other components of the display module. The housing may have a separate mounting portion in which the adhesive material is mounted so that the adhesive material may be positioned at a portion corresponding to the outer edge of the display module. At least a portion of the display module is made of a transparent material, and the adhesive material disposed at the outer edge of the display module may be covered by a bezel area where visual information is not displayed so as not to be visible by a user. Because the bezel of the display module is not an area where an image is output, the bezel may be a factor that hinders the user's sense of immersion in viewing an image due to the limited size of the display module.

According to an embodiment of the disclosure, an area occupied by the bezel of the display module may be reduced. Accordingly, an area in which an image is displayed may increase in a limited display module size.

### [Solution to Problem]

According to an embodiment of the disclosure, an electronic device may include a window layer that is at least partially transparent; a display module disposed under the window layer; a housing including a front surface in which the display module is disposed, a rear surface opposite to the front surface, and a side surface enclosing a space between the front surface and the rear surface; a frame enclosing the side surface of the housing and a side surface of the window layer; a first conduit formed in at least one of one surface of the frame facing the housing or the side surface of the housing facing the frame and extended from a rear surface toward a front surface of the electronic device; and an adhesive material introduced into the first conduit to adhere the side surface of the window layer to the housing and the frame.

According to an embodiment of the disclosure, an adhesive structure of a display module including a window layer may include a housing including a front surface in which the display module is disposed, a rear surface, which is a surface opposite to the front surface, and a side surface enclosing a space between the front surface and the rear surface; a frame enclosing the side surface of the housing and the side surface of the window layer; a first conduit formed in at least one of one surface of the frame facing the housing or the side surface of the housing facing the frame and extended from the rear surface toward the front surface of the housing; a second conduit formed in at least one of one surface of the frame facing the housing or the side surface of the housing facing the frame and extended to enclose the display module and connected to the first conduit; and an adhesive material introduced into the second conduit through the first conduit to adhere the side surface of the window layer to the housing and the frame.

### [Advantageous Effects of Invention]

According to an embodiment of the disclosure, a display module can be fixed to a housing through an adhesive material. In an embodiment, the adhesive material can be disposed at a side surface of the display module. In this case, the adhesive material may not be disposed under an edge of the display module, and a separate mounting portion for disposing the adhesive material may not be formed at the edge of the housing. Accordingly, an area of the bezel for covering the adhesive material and the mounting portion of the housing can be reduced. Accordingly, an area in which an image is displayed can be increased in a limited display module size.

### [Brief Description of Drawings]

In connection with the description of the drawings, the same or similar reference numerals may be used for identical or similar components.
FIG. 1 is a block diagram illustrating an electronic device within a network environment according to an embodiment of the disclosure.
FIG. 2A is a perspective view illustrating a front surface of an electronic device according to an embodiment of the disclosure.
FIG. 2B is a perspective view illustrating a rear surface of the electronic device of FIG. 2A according to an embodiment of the disclosure.
FIG. 3 is an exploded perspective view illustrating the electronic device of FIG. 2A according to an embodiment of the disclosure.
FIG. 4 is an exploded perspective view illustrating a display module according to an embodiment of the disclosure.
FIG. 5A is a diagram illustrating coupling of a frame and a housing according to an embodiment of the disclosure.
FIG. 5B is a front view illustrating a coupled state of a frame and a housing according to an embodiment of the disclosure.
FIG. 6A is a cross-sectional view taken along line A-A' illustrated in FIG. 2A and illustrating a first conduit and a second conduit formed in a frame.
FIG. 6B is a perspective view illustrating a frame and a housing according to an embodiment of the disclosure.
FIGS. 7A and 7B are cross-sectional views taken along line B-B' illustrated in FIG. 2A.
FIGS. 8A to 8C are diagrams illustrating a state in which an adhesive material is introduced into a first conduit and a second conduit formed in a frame according to an embodiment of the disclosure.
FIGS. 9A and 9B are diagrams illustrating various shapes of a first conduit formed in a frame according to an embodiment of the disclosure.
FIGS. 10A and 10B are diagrams illustrating numerical values of a rib of a frame and a first conduit of a frame according to an embodiment of the disclosure.
FIG. 10C is a diagram illustrating a first conduit of a frame viewed from a rear surface of an electronic device according to an embodiment of the disclosure.

### [Mode for the Invention]

In the following description, various embodiments of the present document are described with reference to the attached drawings. It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

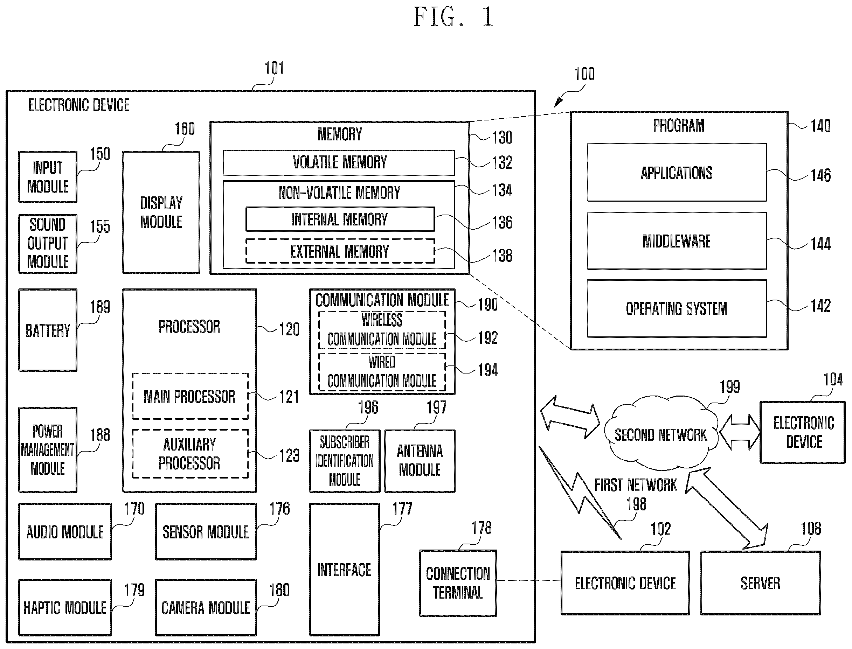

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

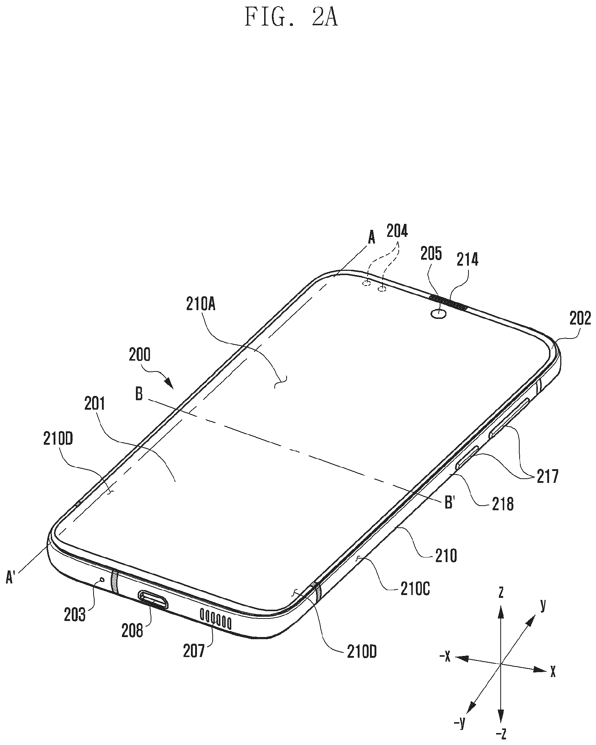

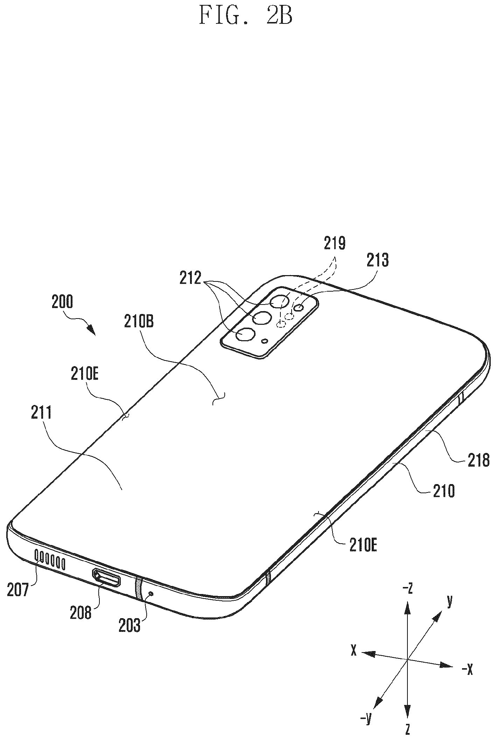

FIG. 2A is a perspective view illustrating a front surface of an electronic device according to an embodiment of the disclosure. FIG. 2B is a perspective view illustrating a rear surface of the electronic device of FIG. 2A according to an embodiment of the disclosure.

An electronic device 200 described below may include at least one of the components of the electronic device 101 described with reference to FIG. 1.

With reference to FIGS. 2A and 2B, the electronic device 200 according to an embodiment may include a housing 210 including a first surface (or front surface) 210A, a second surface (or rear surface) 210B, and a side surface 210C enclosing a space between the first surface 210A and the second surface 210B. In another embodiment (not illustrated), the housing may refer to a structure forming a portion of the first surface 210A, the second surface 210B, and the side surface 210C of FIG. 2A. According to an embodiment, the first surface 210A may be formed by a front plate 202 that is at least partially substantially transparent (e.g., glass plate or polymer plate including various coating layers). The second surface 210B may be formed by a substantially opaque rear plate 211. The rear plate 211 may be made of, for example, coated or colored glass, ceramic, polymer, metal (e.g., aluminum, stainless steel (STS), or magnesium), or a combination of at least two of the materials. The side surface 210C may be formed by a side bezel structure 218 (or "lateral member") for coupling with the front plate 202 and the rear plate 211 and including a metal and/or polymer. In some embodiments, the rear plate 211 and the side bezel structure 218 may be formed integrally and include the same material (e.g., metal material such as aluminum).

In the illustrated embodiment, the front plate 202 may include a first area 210D extended seamlessly from the first surface 210A toward the rear plate at both ends of a long edge of the front plate. In the illustrated embodiment (see FIG. 2B), the rear plate 211 may include a second area 210E extended seamlessly from the second surface 210B toward the front plate at both ends of a long edge. In some embodiments, the front plate 202 or the rear plate 211 may include only one of the first area 210D or the second area 210E. In some embodiments, the front plate 202 may not include a first area and a second area, but may include only a flat plane disposed parallel to the second surface 210B. In the embodiments, when viewed from the side surface of the electronic device, the side bezel structure 218 may have a first thickness (or width) at the side surface that does not include the first area 210D or the second area 210E, and have a second thickness thinner than the first thickness at the side surface that includes the first area 210D or the second area 210E.

According to an embodiment, the electronic device 200 may include at least one of a display 201, an input device 203, sound output devices 207 and 214, sensor modules 204 and 219, camera modules 205 and 212, a key input device 217, an indicator (not illustrated), or a connector 208. In some embodiments, the electronic device 200 may omit at least one (e.g., the key input device 217 or the indicator) of the components or may additionally include other components.

The display 201 may be visually exposed, for example, through a significant portion of the front plate 202. In some embodiments, at least a portion of the display 201 may be exposed through the front plate 202 forming the first surface 210A and the first area 210D of the side surface 210C. The display 201 may be disposed to couple to or adjacent to a touch sensing circuit, a pressure sensor capable of measuring the intensity (pressure) of a touch, and/or a digitizer detecting a magnetic field type stylus pen. In some embodiments, at least a portion of the sensor modules 204 and 219 and/or at least a portion of the key input device 217 may be disposed in the first area 210D and/or the second area 210E.

The input device 203 may include a microphone 203. In some embodiments, the input device 203 may include a plurality of microphones 203 disposed to detect a direction of sound. The sound output devices 207 and 214 may include speakers 207 and 214. The speakers 207 and 214 may include an external speaker 207 and a call receiver 214. In some embodiments, the microphone 203, the speakers 207 and 214, and the connector 208 may be disposed at least partially in an internal space of the electronic device 200 and be exposed to an external environment through at least one hole formed in the housing 210. In some embodiments, the hole formed in the housing 210 may be used jointly for the microphone 203 and the speakers 207 and 214. In some embodiments, the sound output devices 207 and 214 may include a speaker (e.g., piezo speaker) operating without a hole formed in the housing 210.

The sensor modules 204 and 219 may generate an electric signal or data value corresponding to an internal operating state or an external environmental state of the electronic device 200. The sensor modules 204 and 219 may include, for example, a first sensor module 204 (e.g., proximity sensor) and/or a second sensor module (not illustrated) (e.g., fingerprint sensor) disposed at the first surface 210A of the housing 210, and/or a third sensor module 219 (e.g., heart rate monitor (HRM) sensor) disposed at the second surface 210B of the housing 210. The fingerprint sensor may be disposed at the first surface 210A (e.g., home key button) of the housing 210, in a partial area of the second surface 210B, and/or under the display 201. The electronic device 200 may further include at least one of a sensor module not illustrated, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 205 and 212 may include a first camera module 205 disposed at the first surface 210A of the electronic device 200, a second camera module 212 disposed at the second surface 210B of the electronic device 200, and/or a flash 213. The camera modules 205 and 212 may include one or more lenses, an image sensor, and/or an image signal processor. The flash 213 may include, for example, a light emitting diode or a xenon lamp. In some embodiments, two or more lenses (wide angle lens, ultra wide angle lens, or telephoto lens) and image sensors may be disposed at one surface of the electronic device 200.

The key input device 217 may be disposed at the side surface 210C of the housing 210. In another embodiment, the electronic device 200 may not include some or all of the above-mentioned key input devices 217, and the key input devices 217 that are not included may be implemented in another form, such as a soft key, on the display 201. In another embodiment, the key input device 217 may be implemented using a pressure sensor included in the display 201.

The indicator may be disposed, for example, at the first surface 210A of the housing 210. The indicator may provide, for example, state information of the electronic device 200 in the form of light (e.g., light emitting element). In another embodiment, the light emitting element may provide, for example, a light source linked to the operation of the camera module 205. The indicator may include, for example, an LED, an IR LED, and/or a xenon lamp.

The connector hole 208 may include a first connector hole 208 that may receive a connector (e.g., universal serial bus (USB) connector) for transmitting and receiving power and/or data to and from an external electronic device, and/or a second connector hole (or earphone jack) (not illustrated) that may receive a connector for transmitting and receiving audio signals to and from an external electronic device.

Some camera module 205 of the camera modules 205 and 212, some sensor module 204 of the sensor modules 204 and 219, or the indicator may be disposed to be visually exposed through the display 201. For example, the camera module 205, the sensor module 204, or the indicator may be disposed to be in contact with an external environment through a perforated opening or a transparent area from an internal space of the electronic device 200 to the front plate 202 of the display 201. According to an embodiment, an area where the display 201 and the camera module 205 face each other may be formed as a transparent area having a certain transmittance as part of an area that displays contents. According to an embodiment, the transparent area may be formed to have a transmittance in a range of about 5% to about 20%. Such a transparent area may include an area overlapping with an effective area (e.g., a field of view area) of the camera module 205 through which light passes to be imaged by the image sensor to generate an image. For example, the transparent area of the display 201 may include an area having a lower pixel density than that of a peripheral area. For example, the transparent area may replace the opening. For example, the camera module 205 may include an under display camera (UDC). In another embodiment, some sensor module 204 may be disposed to perform functions thereof without being visually exposed through the front plate 202 in the internal space of the electronic device. For example, in such a case, an area of the display 201 facing the sensor module may not require a perforated opening.

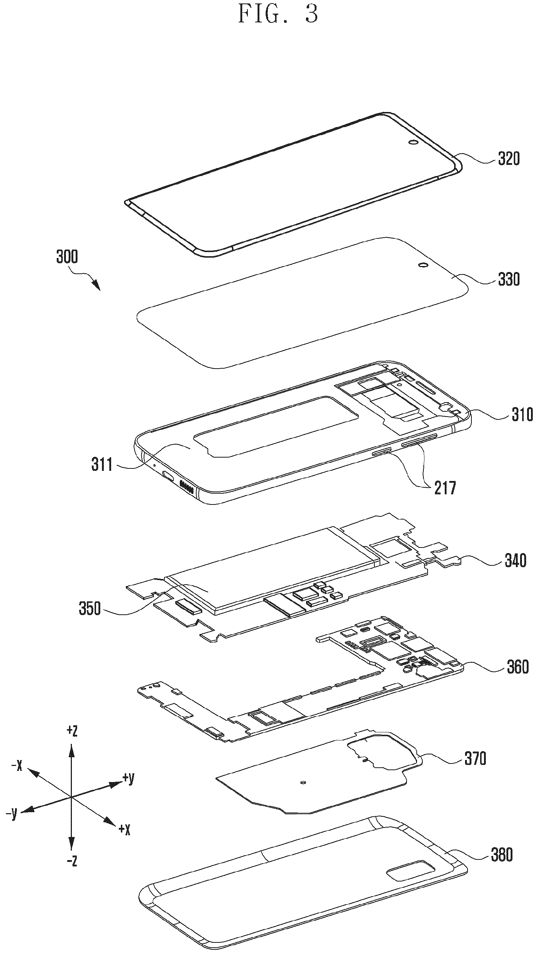

According to an embodiment, the electronic device 200 has a bar type or plate type appearance, but the disclosure is not limited thereto. For example, the illustrated electronic device 200 may be a part of a foldable electronic device, a slidable electronic device, a stretchable electronic device, and/or a rollable electronic device. The terms "foldable electronic device", "slidable electronic device", "stretchable electronic device" and/or "rollable electronic device" may refer to an electronic device in which a display (e.g., a display 330 of FIG. 3) is capable of bending deformation, such that at least a portion thereof is folded, wound or rolled, an area of at least a portion thereof is expanded, and/or the display may be housed inside a housing (e.g., the housing 210 of FIGS. 2A and 2B). The foldable electronic device, the slidable electronic device, the stretchable electronic device, and/or the rollable electronic device may be used by expanding a screen display area by unfolding the display or exposing a wider area of the display to the outside according to the needs of the user.

FIG. 3 is an exploded perspective view illustrating the electronic device of FIG. 2A according to an embodiment of the disclosure.

An electronic device 300 of FIG. 3 may be at least partially similar to the electronic device 200 of FIGS. 2A and 2B or may include other components of the electronic device.

With reference to FIG. 3, the electronic device 300 (e.g., the electronic device 200 of FIG. 2A or 2B) may include a lateral member 310 (e.g., side bezel structure), a first support member 311 (e.g., bracket or support structure), a front plate 320 (e.g., front cover), a display 330 (e.g., the display 201 of FIG. 2A), a substrate 340 (e.g., printed circuit board (PCB), flexible PCB (FPCB), or rigid-flexible PCB (RFPCB)), a battery 350, a second support member 360 (e.g., rear case), an antenna 370, and a rear plate 380 (e.g., rear cover). In some embodiments, the electronic device 300 may omit at least one (e.g., the first support member 311 or the second support member 360) of the components or may additionally include other components. At least one of the components of the electronic device 300 may be identical to or similar to at least one of the components of the electronic device 200 of FIG. 2A or 2B, and a duplicate description will be omitted below.

The first support member 311 may be disposed inside the electronic device 300 to be connected to the lateral member 310 or may be formed integrally with the lateral member 310. The first support member 311 may be made of, for example, a metal material and/or a non-metallic (e.g., polymer) material. The first support member 311 may have the display 330 coupled to one surface and the substrate 340 coupled to the other surface. A processor, a memory, and/or an interface may be mounted on the substrate 340. The processor may include, for example, one or more of a central processer, an application processor, a graphic processer, an image signal processor, a sensor hub processor, or a communication processor.

The memory may include, for example, a volatile memory or a non-volatile memory.

The interface may include, for example, a high definition multimedia interface (HDMI), a universal serial bus (USB) interface, a secure digital (SD) card interface, and/or an audio interface. The interface may, for example, electrically or physically connect the electronic device 300 to an external electronic device and include a USB connector, an SD card/multi-fiber miniature connector (MMC) connector, or an audio connector.

The battery 350 is a device for supplying power to at least one component of the electronic device 300, and may include, for example, a non-rechargeable primary battery, a rechargeable secondary battery, or a fuel cell. At least a portion of the battery 350 may be, for example, disposed on substantially the same plane as that of the substrate 340. The battery 350 may be integrally disposed within the electronic device 300. In another embodiment, the battery 350 may be disposed to be detachable from the electronic device 300.

The antenna 370 may be interposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform short range communication with an external device or wirelessly transmit and receive power required for charging. In another embodiment, an antenna structure may be formed by a part or a combination of the side bezel structure 310 and/or the first support member 311.

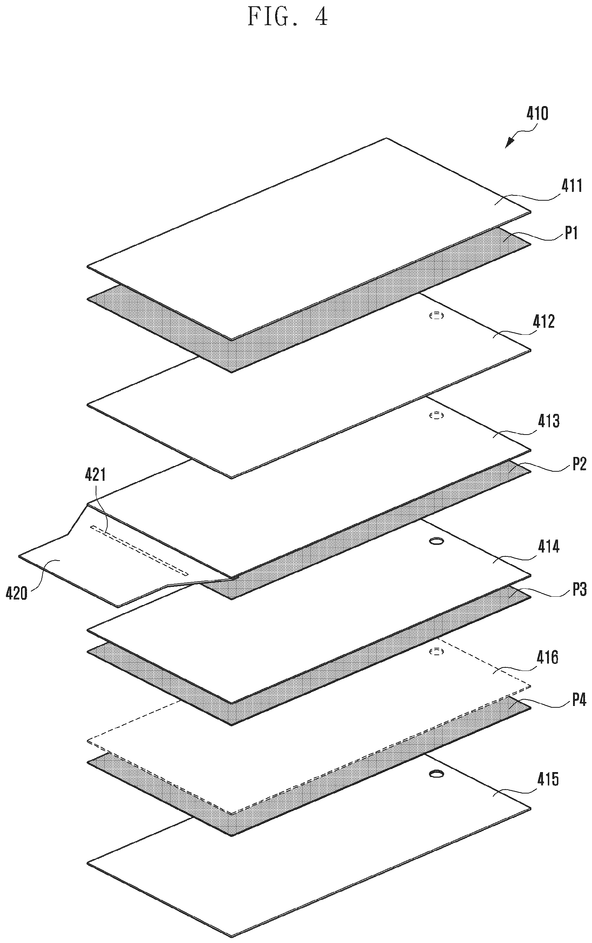

FIG. 4 is an exploded perspective view illustrating a display module according to various embodiments disclosed in this document.

Hereinafter, in the description, a display module 410 may be an example of the display module 160 of FIG. 1, the display 201 of FIG. 2A, and/or the display 330 of FIG. 3. The display module 410 may mean a device for visually displaying information. The display module 410 may be understood as a set of components for visually displaying information. The components of the display module 410 illustrated in FIG. 4 are merely examples of the components included in the display module 410, and the display module 410 may be constituted by omitting some of the components illustrated in FIG. 4, and the display module 410 may be constituted by adding components other than the components illustrated in FIG. 2.

The display module 410 may include a flat type display panel 413 of an on cell touch active matrix organic light-emitting diode (AMOLED OCTA)) method. Further, the display module 410 may include an unbreakable (UB) type OLED display (e.g., curved display) panel 413. Further, a light emitting element constituting the display panel 413 may be implemented into an inorganic light emitting element produced using an inorganic material different from an organic light emitting diode (OLED) produced using an organic material. According to various embodiments, the light emitting element may be a micro light emitting diode (LED) (u-LED). The micro LED may mean an ultra-small inorganic light emitting element having a size of 100 micrometers (µm) or less that emits light by itself without a backlight or a color filter.

With reference to FIG. 4, the display module 410 may include a window layer 411 and a polarizer (POL) 412 (e.g., polarizing film), a display panel 413, a polymer layer 414, and a metal sheet layer 415 sequentially disposed at a rear surface of the window layer 411. In some embodiments, the display panel 413 may include a digitizer panel 416 disposed between the polymer layer 414 and the metal sheet layer 415 or at a rear surface of the metal sheet layer 415.

According to various embodiments, the window layer 411 may include a glass layer. According to an embodiment, the window layer 411 may include ultra thin glass (UTG). In some embodiments, the window layer 411 may include a polymer. In such a case, the window layer 411 may include polyethylene terephthalate (PET) or polyimide (PI). In some embodiments, the window layer 411 may be disposed into a plurality of layers so as to include a glass layer and a polymer.

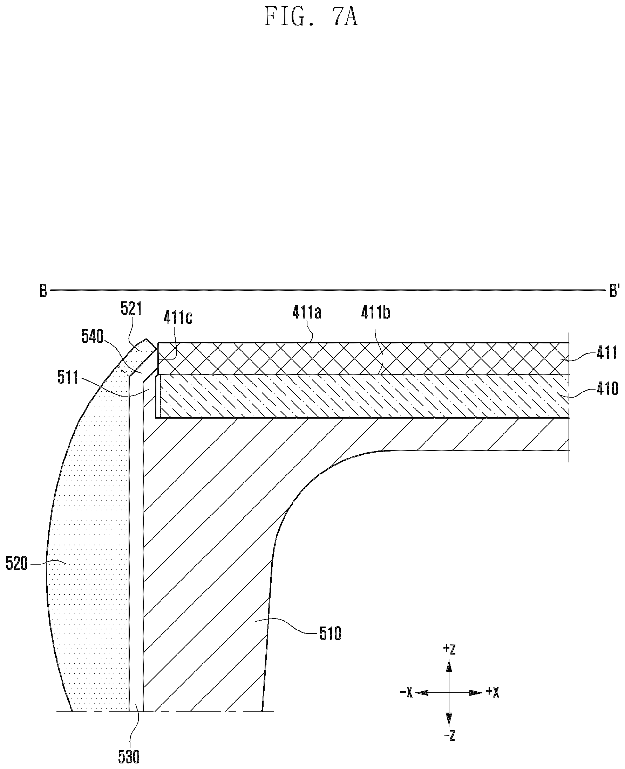

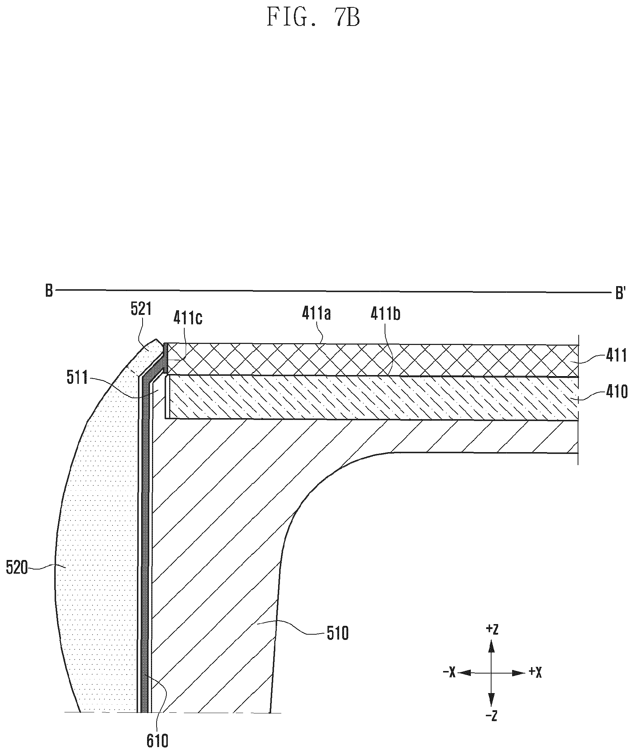

According to an embodiment, the window layer 411 may include a front surface 411a (e.g., a front surface 411a of FIG. 7A), a rear surface 411b (e.g., a rear surface 411b of FIG. 7A), and a side surface 411c (e.g., a side surface 411c of FIG. 7A) enclosing a space between the front surface 411a and the rear surface 411b. The window layer 411 may be mounted in the display module 410 such that the rear surface 411b thereof faces the display module 410. The front surface 411a of the window layer 411 may be exposed to the outside of the electronic device 300 (e.g., the electronic device 101 of FIG. 1, the electronic device 200 of FIG. 2A). An adhesive material 610 (e.g., an adhesive material 610 of FIG. 7B) to be described later may be disposed at the side surface 411c of the window layer 411. The window layer 411 may be coupled to a housing 510 and a frame 520 through the adhesive material 610 applied to the side surface 411c. Accordingly, the display module 410 coupled to the window layer 411 may be fixed to the housing 510 and the frame 520.

According to an embodiment, the window layer 411, the polarizer 412, the display panel 413, the polymer layer 414, and the metal sheet layer 415 may be attached to each other through glues P1, P2, P3, and P4 (or adhesive). For example, the glues P1, P2, P3, and P4 may include at least one of an optical clear adhesive (OCA), a pressure sensitive adhesive (PSA), a heat reactive adhesive, a general adhesive, or a double-sided tape.

According to various embodiments, the display panel 413 may include a plurality of pixels and a wiring structure (e.g., electrode pattern). According to an embodiment, the polarizer 412 may selectively transmit light generated from a light source of the display panel 413 and vibrating in a certain direction. According to an embodiment, the display panel 413 and the polarizer 412 may be formed integrally. According to an embodiment, the display panel 413 may include a touch panel (not illustrated). Components included in the display panel 413 may be disposed on a substrate of the display panel 413. The substrate of the display panel 413 may be made of a rigid material such as glass. In some embodiments, the substrate of the display panel 413 may be made of a flexible material. For example, the substrate may be made of flexible materials such as polyimide (PI), polyethylene terephthalate (PET), and/or ultra-thin-glass (UTG).

According to various embodiments, the polymer layer 414 may be disposed under the display panel 413 to provide a dark background for securing visibility of the display panel 413 and be made of a cushioning material (e.g., cushion) for cushioning. For example, the polymer layer 414 may include an opaque metal layer (e.g., a black layer including an uneven pattern) for removing air bubbles that may be generated between the display panel 413 and lower attachments thereof and blocking light generated in the display panel 413 or light incident from the outside, and/or a cushioning layer (e.g., sponge layer) disposed for shock absorption. In some embodiments, for waterproofing the display module 410, the polymer layer 414 may be removed or disposed under the metal sheet layer 415.

According to an embodiment, the metal sheet layer 415 may include at least one of steel use stainless (SUS), Cu, Al, or metal CLAD (e.g., a laminated member in which SUS and Al are alternately disposed). In some embodiments, the metal sheet layer 415 may include other alloy materials. In some embodiments, the metal sheet layer 415 may help reinforce rigidity of the electronic device 300 and be used for shielding ambient noise and dispersing a heat emitted from peripheral heat dissipating components. Although FIG. 4 illustrates that the metal sheet layer 415 has the same area as that of the display panel 413, in some embodiments, the metal sheet layer 415 may be disposed in a portion of the display panel 413. In some cases, the metal sheet layer 415 may be omitted.

According to various embodiments, the digitizer panel 416 may be disposed between the metal sheet layer 415 and the polymer layer 414. In some cases, the digitizer panel 416 may be disposed under the metal sheet layer 415. The digitizer panel 416 may be a detection member that receives an input from a pen input device (e.g., stylus).

According to various embodiments, the display module 410 may include a bending portion 420 disposed in a manner of folding (e.g., bending) in at least a partial area of the rear surface of the display module 410 from the display panel 413. According to an embodiment, the bending portion 420 may be electrically connected to the display panel 413. The bending portion 420 may include a display driver IC (DDI) 421. In some embodiments, the bending portion 420 connected to the display panel 413 may include both a DDI 421 and a touch display driver IC (TDDI) (not illustrated).

In an embodiment, the bending portion 420 may be formed integrally with the substrate of the display panel 413. The bending portion 420 may be a part of the substrate on which the light emitting element of the display panel 413 is disposed. The bending portion 420 may include a portion that is extended from the substrate of the display panel 413 and that is at least partially deformed to be extended to the rear surface of the display panel 413. In an embodiment, the display module 410 may include a chip on panel (COP) structure in which the DDI 421 is disposed in the bending portion 420 formed integrally with the substrate of the display panel 413.

In an embodiment, the bending portion 420 may be formed separately from the substrate of the display panel 413 to be electrically connected to the display panel 413. In this case, the bending portion 420 may be a printed circuit board (e.g., flexible printed circuit board (FPCB)) made of a flexible material. The bending portion 420 connected to the display panel 413 may be partially deformed to be extended to the rear surface of the display panel 413. In an embodiment, the display module 410 may include a chip on film (COF) structure in which the DDI 421 is disposed at the bending portion 420 electrically connected to the display panel 413.

According to an embodiment, the display module 410 may include a display area where visual information is displayed and a bezel area where visual information is not displayed. The bezel area may cover an adhesive member disposed under the display module 410 or an electrical wiring of the display module. In an embodiment, the bezel area may cover an adhesive member disposed at an outer edge of the display module 410, the bending portion 420, and/or a portion of the circuit wiring of the display module 410 so that it is not visible to the user. In an embodiment, the bezel area may be an area printed in black at an outer edge of the window layer 411 disposed in the display module 410. In some embodiments, the bezel area may be a tape attached to an outer edge of the display module 410.

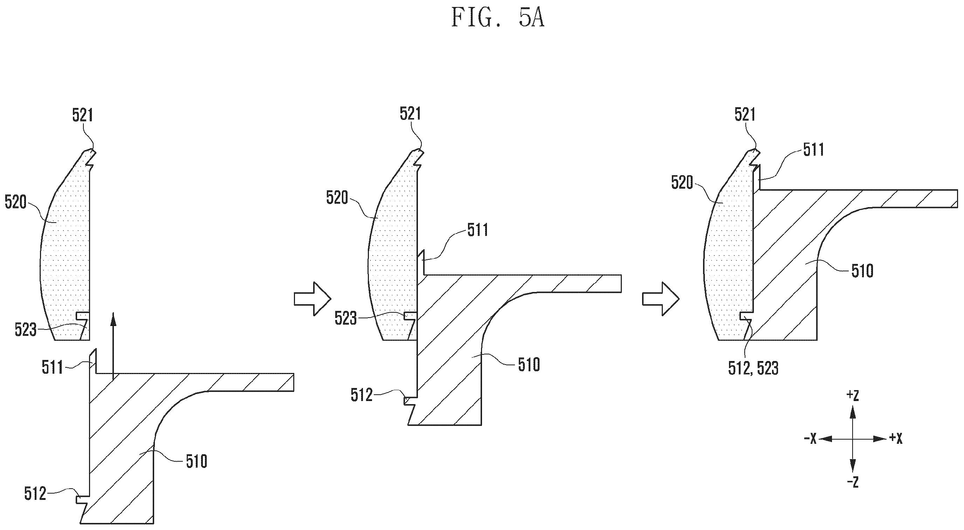

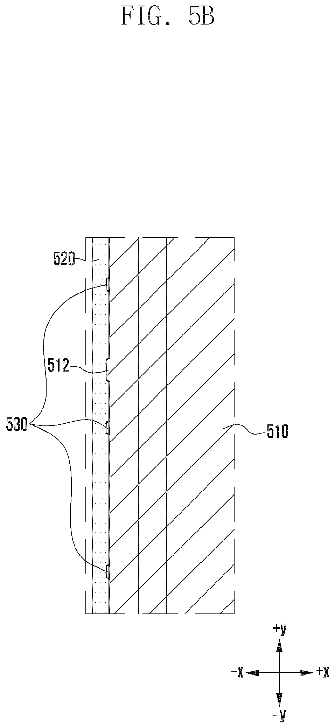

FIG. 5A is a diagram illustrating coupling of a frame and a housing according to an embodiment of the disclosure. FIG. 5B is a front view illustrating a coupled state of the frame and the housing according to an embodiment of the disclosure.

According to an embodiment, as illustrated in FIG. 5A, the electronic device 300 (e.g., the electronic device 101 of FIG. 1, the electronic device 200 of FIG. 2A or 2B) may include a frame 520 (e.g., the side bezel structure 218 of FIG. 2A or the lateral member 310 of FIG. 3). The frame 520 may be disposed at the side surface (e.g., the side surface 210c of FIG. 2A) of a housing 510 (e.g., the housing 210 of FIG. 2A) to form a side surface appearance of the electronic device 300. In an embodiment, the side surface of the electronic device 300 may mean a surface excluding a front surface (e.g., a surface facing the +Z direction of FIG. 4) and a rear surface (e.g., a surface facing the -Z direction of FIG. 4) of the electronic device 300.

According to an embodiment, the frame 520 may be disposed to enclose a side surface of the housing 510 and the display module 410 (e.g., the display module 160 of FIG. 1, the display 201 of FIG. 2A, or the display 330 of FIG. 3) of the electronic device 300. In an embodiment, the frame 520 may enclose the window layer 411, which is an outermost layer of the display module 410. For example, the frame 520 may face the side surface 411c of the window layer 411.

According to an embodiment, as illustrated in FIGS. 5A and 5B, the frame 520 may be coupled to the housing 510 to enclose a side surface of the housing 510. The frame 520 may be coupled to the housing 510 in various ways. In an embodiment, the housing 510 may include a protrusion 512 protruded toward the frame 520 at a side surface facing the frame 520. The frame 520 may include a groove 523 into which the protrusion 512 of the housing 510 is inserted. As the protrusion 512 of the housing 510 is fastened to the groove 523, the frame 520 may be coupled to the housing 510. In an embodiment, with reference to FIG. 5A, the frame 520 may be slidably fastened to the housing 510. For example, the frame 520 may slide along the side surface of the housing 510, and the protrusion of the housing 510 may be fastened to the groove 523 of the frame 520. Accordingly, the frame 520 may be fixed to the housing 510.

In an embodiment, the protrusion 512 may include a hook formed in a bent shape at the end. The groove 523 formed in the frame 520 may include a fastening portion to which the hook of the protrusion 512 is fastened. As the hook of the protrusion 512 formed in the housing 510 is fastened to the groove 523, the frame 520 may be fixed to the housing 510.

In some embodiments not illustrated in the drawings, the frame 520 may be fixed to the housing 510 through an adhesive material such as a double-sided tape or bond. Further, the frame 520 may be fixed to the housing 510 in various ways.

According to an embodiment, the housing 510 may be made of various materials. In an embodiment, the housing 510 may be made of a conductive material such as a metal material. For example, the housing 510 may be made of a metal material including aluminum (Al). This is only an example, and the housing 510 may be made of various metal materials. Further, in some embodiments, the housing 510 may be made of a non-metallic material such as a synthetic resin, ceramic, or engineering plastic.

Likewise, the frame 520 may be made of various materials. In an embodiment, the frame 520 may be made of a conductive material such as a metal material. For example, the housing 510 may be made of a metal material including aluminum (Al). This is merely an example, and the frame 520 may be made of various metal materials. In the case that the frame 520 is made of a metal material, the frame 520 may be used as an antenna of the electronic device 300. For example, the frame 520 may be electrically connected to a communication module of the electronic device 300 to transmit or receive a communication signal (e.g., RF signal) to or from an external device. In an embodiment, the frame 520 may be electrically connected to the communication module through an RF wiring. Here, the RF wiring may be a component that transfers a radio frequency (RF) signal. The RF wiring may transfer an RF signal processed in a communication module of the electronic device 300 to the frame 520 that acts as an antenna or transfer an RF signal received in the frame 520 to the communication module. In some embodiments, the frame 520 may be made of a non-metallic material such as a synthetic resin, ceramic, or engineering plastic. The materials of the housing 510 and the frame 520 described above are merely examples, and the housing 210 may be variously changed within a range that may be implemented by a person skilled in the art.

According to an embodiment, the display module 410 may be fixed to the housing 510 through an adhesive member (e.g., the adhesive material 610). In an embodiment, the adhesive member may be positioned at an outer edge of the display module 410 so as to avoid interference with other components (e.g., wiring) of the display module 410. In an embodiment, the housing 510 may have a separate mounting portion in which the adhesive member is mounted so that the adhesive member may be positioned at a portion corresponding to the outer edge of the display module 410. At least a portion of the display module 410 is made of a transparent material, and the adhesive member disposed at the outer edge of the display module 410 may be covered by a bezel area where visual information is not displayed so as not to be visible by the user. The bezel of the display module 410 may be positioned at the outer edge of the display module 410. Because the bezel of the display module 410 is not an area where an image is output, the bezel may be a factor that hinders the user's sense of immersion in viewing an image due to the limited size of the display module 410. According to an embodiment of the disclosure, the adhesive member may be disposed at a side surface of the display module 410 to fix the display module 410 to the housing 510 and the frame 520. For example, the adhesive material 610 may be disposed at the side surface 411c of the window layer 411 of the display module 410 to fix the window layer 411 to the housing 510 and the frame 520. Accordingly, the adhesive material 610 and a separate mounting portion in which the adhesive material 610 is mounted may not be formed under the outer edge of the display module 410. Accordingly, an area of the bezel for covering the mounting portion of the housing 510 and the adhesive material 610 may be reduced. Therefore, an area in which an image is displayed may increase in a limited size of the display module 410.

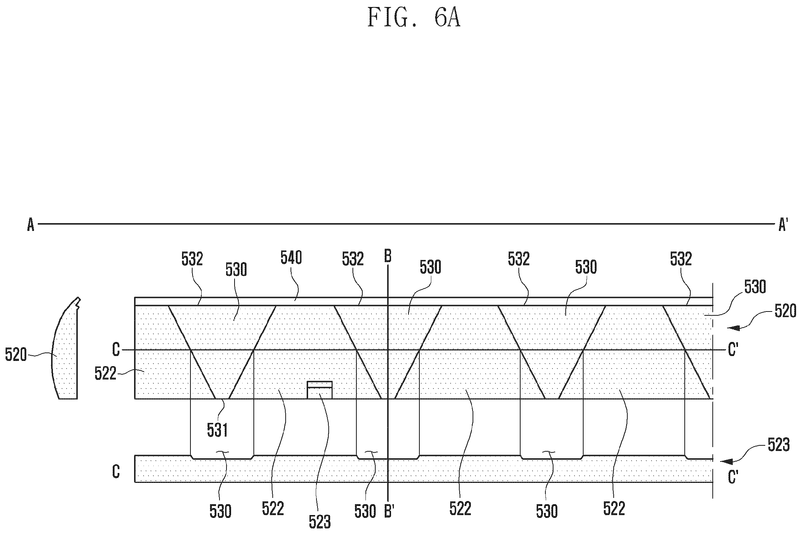

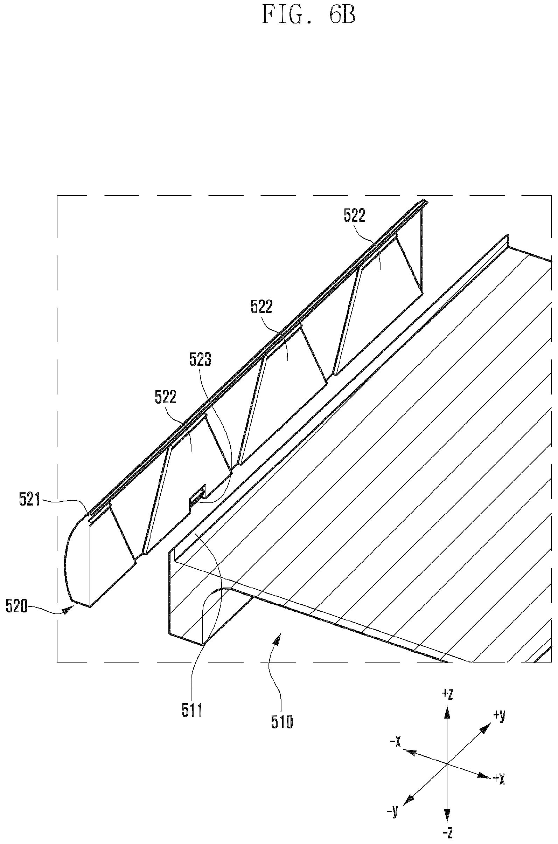

Hereinafter, as a structure formed in the housing 510 or the frame 520, a channel in which the adhesive material 610 is introduced into the side surface of the display module 410 will be described. The "channel (e.g., a first conduit 530 and a second conduit 540 of FIGS. 6A and 6B)" may mean a physical space in which the adhesive material 610 flows. The channel may be a space formed through coupling of devices. In an embodiment, with reference to FIG. 5B, a channel into which the adhesive material 610 is introduced may be a space formed when peripheries of the first conduit 530 and the second conduit 540, which are each engraved at one surface of the frame 520, are sealed through the housing 510. In some embodiments, the channel may be a space formed when peripheries of the first conduit 530 and the second conduit 540, which are each engraved at one surface of the housing 510 are sealed through the frame 520.

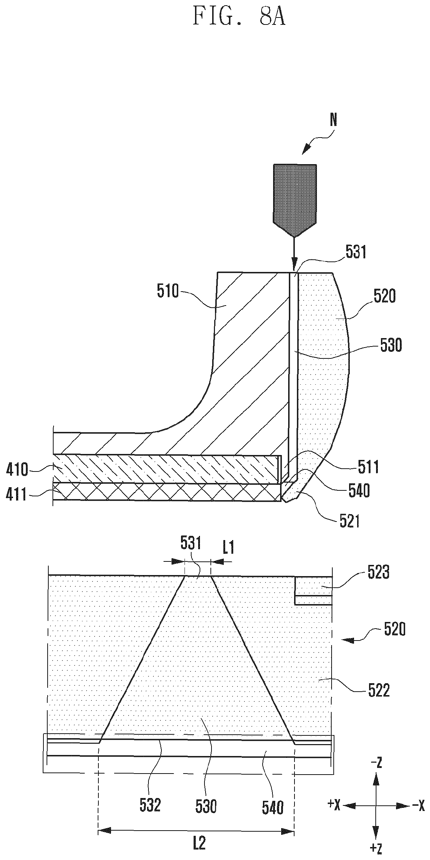

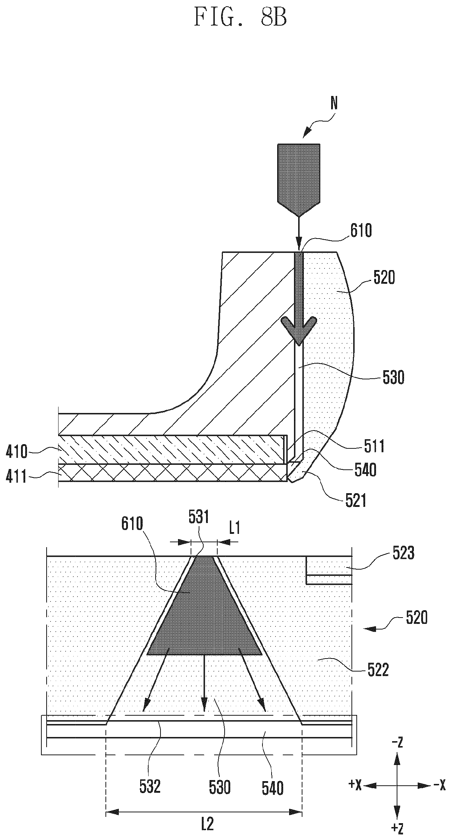

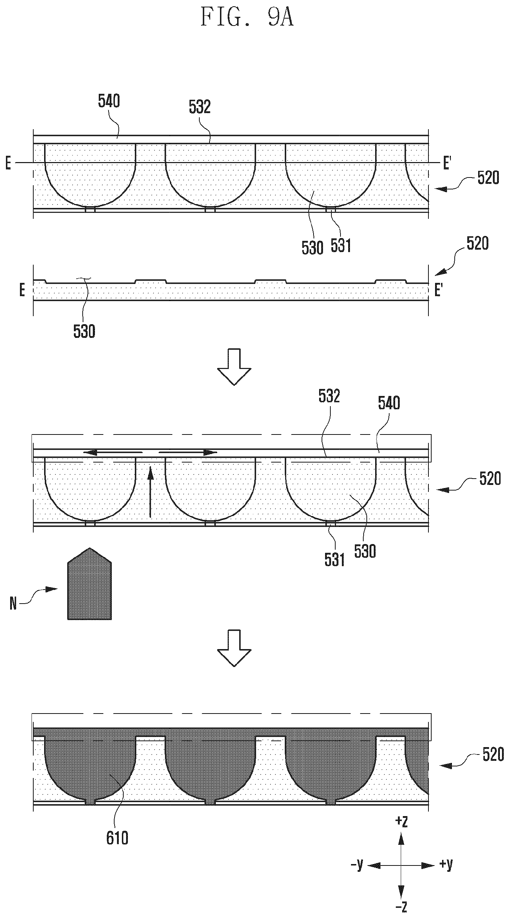

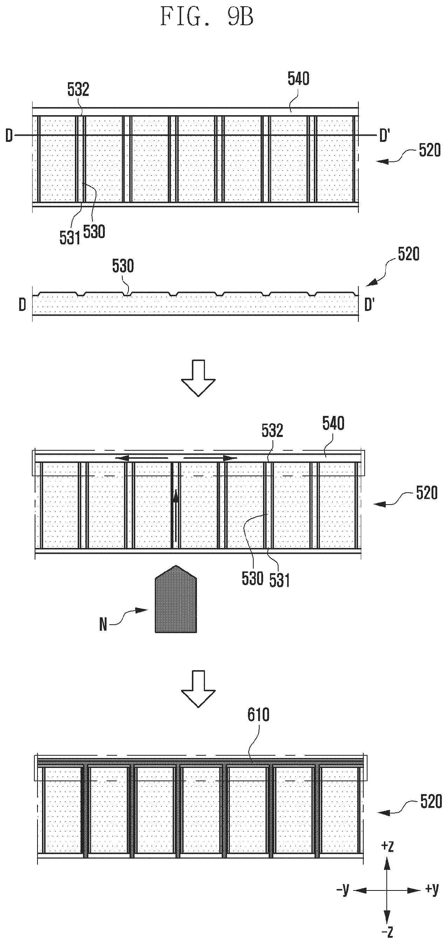

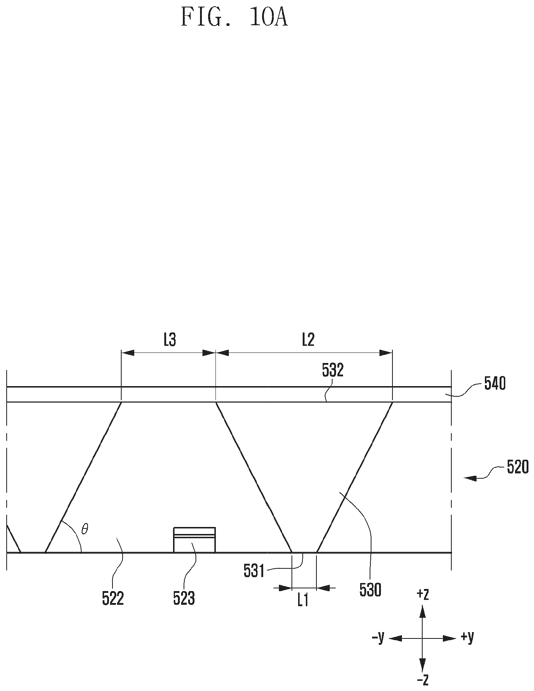

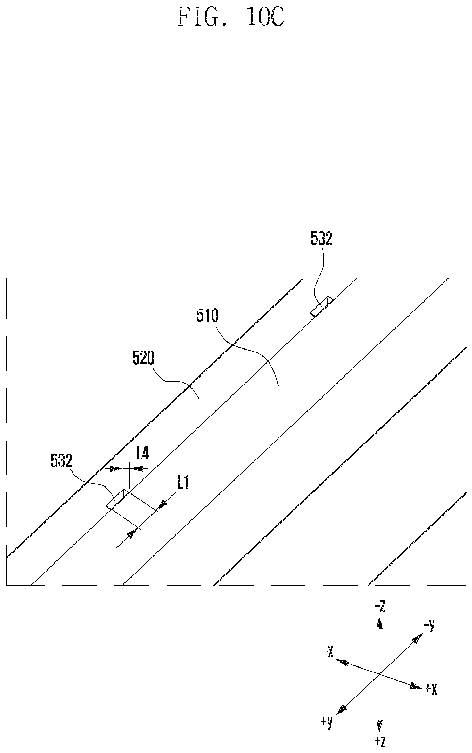

FIG. 6A is a cross-sectional view taken along line A-A' of FIG. 2A and illustrating a first conduit and a second conduit formed in a frame. FIG. 6B is a perspective view illustrating a frame and a housing according to an embodiment of the disclosure. FIGS. 7A and 7B are cross-sectional views taken along line B-B' of FIG. 2A. FIGS. 8A to 8C are diagrams illustrating a state in which an adhesive material is introduced into a first conduit and a second conduit formed in a frame according to an embodiment of the disclosure. FIGS. 9A and 9B are diagrams illustrating various shapes of a first conduit formed in a frame according to an embodiment of the disclosure. FIGS. 10A to 10B are diagrams illustrating numerical values of a rib of a frame and a first conduit of the frame according to an embodiment of the disclosure. FIG. 10C is a diagram illustrating a first conduit of a frame viewed from a rear surface of an electronic device according to an embodiment of the disclosure.

According to an embodiment, as illustrated in FIGS. 6A and 6B, a conduit (e.g., the first conduit 530, the second conduit 540 of FIGS. 6A and 6B) into which the adhesive material 610 is inserted may be formed in at least one of the housing 510 (e.g., the housing 210 of FIG. 2A) or the frame 520 (e.g., the side bezel structure 218 of FIG. 2A or the lateral member 310 of FIG. 3). In an embodiment, the first conduit 530 may be formed at one surface of the frame 520 facing the housing 510. In an embodiment, the first conduit 530 may be extended from the rear surface toward the front surface (e.g., in the Z-axis direction of FIG. 6A) of the electronic device 300 (e.g., the electronic device 101 of FIG. 1, the electronic device 200 of FIG. 2A). As the frame 520 and the housing 510 are coupled, a periphery of the first conduit 530 may be sealed. Accordingly, the adhesive material 610 may be injected between the housing 510 and the frame 520 through the first conduit 530. Further, in some embodiments not illustrated in the drawing, the first conduit 530 may be formed at one side surface of the housing 510 facing the frame 520. The adhesive material 610 may be injected between the housing 510 and the frame 520 through the first conduit 530 formed in the housing 510.

In an embodiment, with reference to FIGS. 6A and 6B, the frame 520 may include a second conduit 540 connected to the first conduit 530. The second conduit 540 may be formed along a longitudinal direction (e.g., the Y-axis direction of FIG. 6A) of the frame 520. In an embodiment, the second conduit 540 may face a portion of the side surface of the display module 410 (e.g., the display module 160 of FIG. 1, the display 201 of FIG. 2A, and/or the display 330 of FIG. 3). In an embodiment, the second conduit 540 may be formed along an extension direction of the frame 520. In an embodiment, the second conduit 540 may be formed in the frame 520 along the side surface 411c of the window layer 411. For example, the second conduit 540 may face at least a portion of the side surface 411c of the window layer 411 laminated on the display module 410. Accordingly, the adhesive material 610 to be described later may be injected into the second conduit 540 through the first conduit 530 to be applied to the side surface 411c of the window layer 411.

In an embodiment, with reference to FIGS. 6A and 6B, the first conduit 530 may include a first hole 531 formed at the rear surface of the frame 520 (e.g., a surface facing the -Z direction based on FIG. 6A) and a second hole 532 formed at the front surface of the frame 520 (e.g., a surface facing the +Z direction based on FIG. 6A). In an embodiment, the first hole 531 may be an inlet in which the adhesive material 610 is introduced into the first conduit 530 through a nozzle N. The second hole 532 may be an outlet in which the adhesive material 610 passes through the first conduit 530 and an inlet in which the adhesive material 610 is introduced into the second conduit 540. The second conduit 540 may be connected to the first conduit 530 through the second hole 532. Accordingly, the adhesive material 610 may be introduced into the first conduit 530 through the first hole 531, pass through the second hole 532, and then be introduced into the second conduit 540.

In an embodiment, the first conduit 530 may be formed in the frame 520 in various numbers. In an embodiment, the first conduit 530 may be positioned in at least one of every side surface of the electronic device 300. In some embodiments, the first conduit 530 may be formed in the frame 520 so as to be positioned at a corner of the electronic device 300.

In the above description, it is described that the first conduit 530 and the second conduit 540 are formed at one side surface of the frame 520 facing the housing 510, but forming positions of the first conduit 530 and the second conduit 540 may not be limited to the frame 520. In an embodiment not illustrated in the drawing, the first conduit 530 and the second conduit 540 may be formed at one surface of the housing 510 facing the frame 520. In an embodiment, the first conduit 530 may be formed at one surface of the housing 510 from the rear surface toward the front surface (e.g., the Z-axis direction of FIG. 6B) of the electronic device 300. The second conduit 540 may be formed along a longitudinal direction of the housing 510 (e.g., the Y-axis direction of FIG. 6B) to be connected to the first conduit 530. The first hole 531, which is an inlet in which the adhesive material 610 is introduced into the first conduit 530, may be formed at the rear surface of the housing 510 (e.g., a surface facing the -Z direction based on FIG. 6B), and the second hole 532 may be formed at the front surface of the housing 510 (e.g., a surface facing the +Z direction based on FIG. 6B). Accordingly, the adhesive material 610 may be introduced into the first conduit 530 through the first hole 531, pass through the second hole 532 of the first conduit 530 to be introduced into the second conduit 540 and be diffused along the side surface of the window layer 411, and be applied to the side surface 411c of the window layer 411. In an embodiment, as the first conduit 530 and the second conduit 540 are in a vacuum state, the adhesive material 610 may be easily sucked in and diffused.

Hereinafter, for convenience of description, it is assumed that the first conduit 530 and the second conduit 540 are formed at one surface of the frame 520. However, the following description may be applied equally to the case that the first conduit 530 and the second conduit 540 are formed at one surface of the housing 510 facing the frame 520.

According to an embodiment, as illustrated in FIGS. 7A and 7B, the adhesive material 610 may be injected into the second conduit 540 through the first conduit 530. The adhesive material 610 may be introduced into the first conduit 530 through the first hole 531, which is an inlet of the first conduit 530. Thereafter, the adhesive material 610 may be introduced into the second conduit 540 through the second hole 532, which is an outlet of the first conduit 530 and an inlet of the second conduit 540. As described above, the second conduit 540 may face a portion of the side surface of the display module 410. For example, the second conduit 540 may face the side surface 411c of the window layer 411 positioned at an outermost layer of the display module. The adhesive material 610 may be adhered to a portion of the side surface of the display module 410 as it is introduced into the second conduit 540. Specifically, the adhesive material 610 may be adhered to the side surface 411c of the window layer 411. Accordingly, the window layer 411 may be adhered to the housing 510 and the frame 520 through the adhesive material 610. According to an embodiment of the disclosure, the adhesive material 610 may be applied to the frame 520, the housing 510, and the window layer 411 through the first conduit 530 and the second conduit 540 formed in the frame 520. Accordingly, the frame 520 may be coupled to the housing 510 through the adhesive material 610, and the display module 410 may be fixed to the housing 510 and the frame 520 through the adhesive material 610 adhered to the window layer 411.

According to an embodiment, as illustrated in FIGS. 7A and 7B, the frame 520 may include a side surface portion 521 extended toward the display module 410 from one surface facing the housing 510. In an embodiment, the side surface portion 521 of the frame 520 may not overlap the display module 410 when the display module 410 is viewed in a vertical direction (e.g., the -Z direction of FIG. 7A). In some embodiments, the side surface portion 521 of the frame 520 may overlap a portion of an edge of the display module 410 when the display module 410 is viewed in a vertical direction (e.g., the -Z direction of FIG. 7A). In this case, an edge area of the display module 410 may be protected by the side surface portion 521 of the frame 520.

According to an embodiment, as illustrated in FIGS. 7A and 7B, the display module 410 may be disposed in the housing 510. The housing 510 may include a partition 511 enclosing the display module. In an embodiment, the partition 511 may prevent the adhesive material 610 introduced through the first conduit 530 and the second conduit 540 from being adhered to the remaining components of the display module 410 except for the window layer 411. Further, the partition 511 may protect the display module 410 from an impact applied to the electronic device 300.

In an embodiment, with reference to FIGS. 7A and 7B, the display module 410 may be spaced apart from the partition 511 by a predetermined distance. In this case, an empty space is generated between the side surface of the display module 410 and the partition 511; thus, an impact applied to the partition 511 may not be directly transferred to the display module 410. Accordingly, the display module 410 may be protected from an external impact.

In an embodiment, with reference to FIG. 7B, the adhesive material 610 may be guided to the side surface 411c of the window layer 411 through the partition 511 of the housing 510 and the side surface portion 521 of the frame 520. For example, the adhesive material 610 may be introduced into the second conduit 540 through the first conduit 530 and pass through between the side surface portion 521 of the frame 520 and the partition 511 of the housing 510 to be applied to the side surface 411c of the window layer 411. Accordingly, the adhesive material 610 may adhere the window layer 411 to the side surface portion 521 of the frame 520 and the partition 511 of the housing 510.

According to an embodiment of the disclosure, a series of processes in which the adhesive material 610 is introduced into the side surface of the display module 410 may be as follows. In an embodiment, with reference to FIGS. 8A to 8C, the adhesive material 610 may be introduced from the nozzle N into the first hole 531 of the first conduit 530 formed in the frame 520. The adhesive material 610 may pass through the second hole 532 of the first conduit 530 to be introduced into the second conduit 540. The adhesive material 610 may pass through between the side surface portion 521 of the frame 520 and the partition 511 of the housing 510 to be applied to the side surface 411c of the window layer 411. The display module 410 may be coupled to the housing 510 and the frame 520 through an adhesive material 610 applied to the side surface 411c of the window layer 411. As the adhesive material 610 is positioned at the side surface 411c of the glass layer 411, an area occupied by the bezel of the display module 410 for covering the adhesive material 610 may be reduced. Accordingly, an area in which an image is displayed may be increased in the limited size of the display module 410.

According to an embodiment, as illustrated in FIGS. 8A to 9B, the first conduit 530 may be formed in the frame 520 in various shapes. In an embodiment, the shape of the first conduit 530 may be determined in consideration of a speed at which the adhesive material 610 is introduced into the second conduit 540. In an embodiment, with reference to FIGS. 8A to 8C, a width L2 of the second hole 532 of the first conduit 530 may be wider than a width L1 of the first hole. In an embodiment, a cross sectional area of the first conduit 530 may be a trapezoidal shape in which the width of the second hole 532 is wider than that of the first hole 531. Further, in an embodiment, with reference to FIG. 9A, the first conduit 530 may be formed in a semicircular shape in the frame 520 so that the second hole 532 of the first conduit 530 has a larger area than the first hole 531 thereof. In this case, because a shape has a wider area as it progresses from the first hole 531 to the second hole 532, the time in which the adhesive material 610 is filled in the second conduit 540 may be shortened.

In an embodiment, with reference to FIG. 9B, a width L1 of the first hole 531 and a width L2 of the second hole 532 of the first conduit 530 may be formed in the frame 520 to have the same width. In an embodiment, the first conduit 530 may be formed in a straight shape from the rear surface toward the front surface of the frame 520 so that the width L1 of the first hole 531 and the width L2 of the second hole 532 are the same. In this case, an amount in which the adhesive material 610 is introduced into the first conduit 530 is reduced; thus, a production cost of the product may be reduced. In an embodiment, compared to the example of FIG. 8A, the number of first conduits 530 per unit area that may be formed in the frame 520 may be increased. In this case, while shortening the time in which the adhesive material 610 is filled into the second conduit 540, by reducing an amount in which the adhesive material 610 is introduced into the first conduit 530, a production cost of the product may be reduced.

According to an embodiment, as illustrated in FIG. 10A, the frame 520 may include a first conduit 530 and a rib 522. The rib 522 may be constituted to partition a plurality of first conduits 530 in the frame 520. In an embodiment, the rib 522 may be one surface of the frame 520 interposed between the plurality of first conduits 530 as the first conduits 530 are engraved in the frame 520. In an embodiment, a shape of the rib 522 may be determined based on a shape of the first conduit 530. For example, with reference to FIG. 10A, the first conduit 530 may have a trapezoidal shape in which the width (e.g., the length in the Y-axis direction based on FIG. 10A) becomes longer from the rear surface (e.g., a surface facing the -Z direction based on FIG. 10A) to the front surface (e.g., the surface facing the +Z direction based on FIG. 10A) of the frame 520. In this case, the rib 522 interposed between the plurality of first conduits 530 may have a trapezoidal shape in which the width becomes narrower from the rear surface toward the front surface of the frame 520.

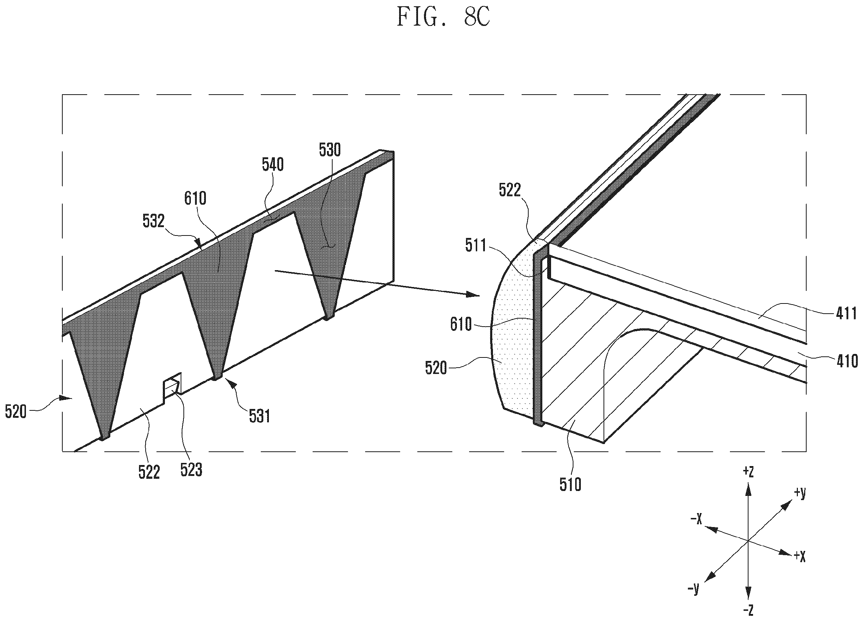

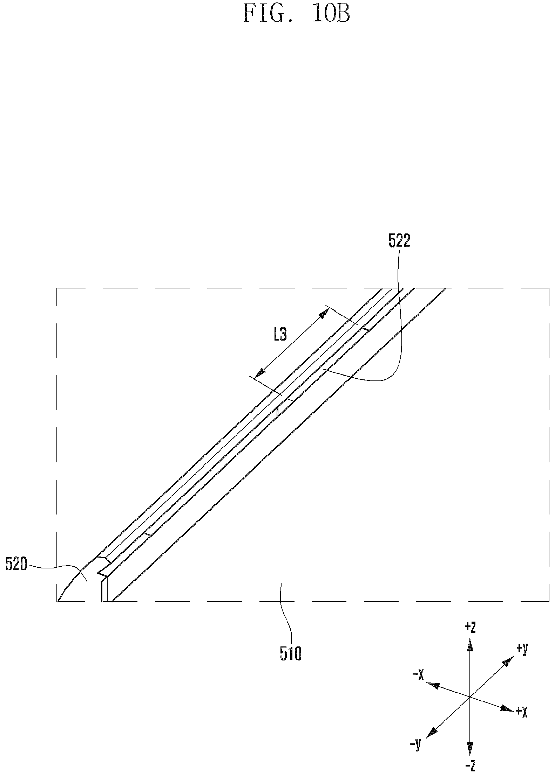

In an embodiment, with reference to FIGS. 10A and 10B, one surface of the rib 522 may form a part of the second conduit 540. For example, the adhesive material 610 introduced into the second conduit 540 may be diffused along one surface of the rib 522 in the longitudinal direction of the frame 520 (e.g., the Y-axis direction of FIG. 8C or the Y-axis direction of FIG. 10A). A width L3 of one surface of the rib 522 through which the adhesive material 610 passes may be determined in consideration of the diffusion speed of the adhesive material 610. For example, the longer the width L3 of the rib 522 through which the adhesive material 610 passes, the lower the diffusion speed of the adhesive material 610. Therefore, as illustrated in FIGS. 10A and 10B, one surface of the rib 522 through which the adhesive material 610 passes may be formed to have a width L3 of about 3 to 4 mm in consideration of the diffusion speed of the adhesive material 610. In some embodiments, the rib 522 may be formed in a triangular shape. In this case, the adhesive material 610 passing through the second conduit 540 may pass through a triangular vertex of the rib 522. In this case, the adhesive material 610 may have reduced contact resistance with the rib 522; thus, the speed at which the adhesive material 610 is diffused into the second conduit 540 may increase.

In an embodiment, the rib 522 may be formed to have a specific angle θ in consideration of a speed at which the adhesive material 610 is diffused into the second conduit 540. In an embodiment, with reference to FIG. 10A, a side surface of the rib 522 may be inclined at a specific angle θ with respect to a rear surface of the frame 520. In an embodiment, an angle formed between the side surface of the rib 522 and the frame 520 may be an angle between about 50 degrees and about 60 degrees. Further, the angle formed between the side surface of the rib 522 and the frame 520 may be designed based on the speed at which the adhesive material 610 is diffused from the first conduit 530 to the second conduit 540.

In an embodiment, with reference to FIG. 10C, the first hole 531, which is an inlet of the first conduit 530, may be formed in various sizes. In an embodiment, the size of the first hole 531 may be determined in consideration of an amount in which the adhesive material 610 is filled in the first conduit 530. For example, when the first conduit 530 is excessively filled with adhesive material 610, a production cost of the product may increase. Therefore, the first conduit 530 may be designed in a structure in which the width (e.g., the length in the Y-axis direction based on FIG. 10B) becomes wider as it progresses from the first hole 531 to the second hole 532 in consideration of a speed at which the adhesive material 610 is diffused from the first conduit 530 to the second conduit 540 and a production cost of the product. In an embodiment, a width L1 of the first hole 531 may be about 1 to 2 mm, and a width L4 thereof may be about 0.2 to 0.5 mm. Further, the first hole 531 may be formed in various sizes.

According to an embodiment, the adhesive material 610 may be liquid. In an embodiment, the adhesive material may be made of various materials such as polyurethane, acrylate, silicone, ester rubber, phenol resin, castor oil, polyisobutylene, epoxy resin, cyanoacrylate, and bis-acrylate. Further, the adhesive material 610 may be made of various materials that may be performed by a person skilled in the art. Further, in some embodiments, the adhesive material 610 may be a solid material.

In an embodiment, the adhesive material 610 may be solidified in various ways. The adhesive material 610 may be a hot-melt adhesive made of a thermoplastic resin. For example, the adhesive material 610 may be a material that is solid at room temperature but becomes liquid in a temperature above a melting point thereof by heating to a certain temperature. In this case, the adhesive material 610 may be applied to an adherend (e.g., the first conduit 530, the second conduit 540, the side surface 411c of the window layer 411) and be solidified by cooling to form an adhesive force. The adhesive material 610 may be introduced into the first conduit 530 through the first hole 531 in a liquid state heated to a temperature above a melting point thereof and pass through the second hole 532 of the first conduit 530 to be introduced into the second conduit 540 and to be diffused along the side surface 411c of the window layer 411. Accordingly, the adhesive material 610 may be applied to the side surface 411c of the window layer 411. Further, the adhesive material 610 may be one of adhesives that are cured by various methods, such as a heat-curing adhesive that forms an adhesive force by being applied to an adherend and then cured when exposed to heat, a room temperature-curing adhesive that forms an adhesive force by being applied to an adherend and then cured at a room temperature, and a pressure-sensitive adhesive that maintains an adhesive force by applying an external force to an adherend.

The electronic device 300 described above has a bar type or plate type appearance, but the disclosure is not limited thereto. For example, the first conduit and the second conduit that adhere the window layer and the housing of the display module of the disclosure may be applied to various types of electronic devices. For example, the illustrated electronic device 200 may be applied to a foldable electronic device, a slidable electronic device, a stretchable electronic device, and/or a rollable electronic device. The terms "foldable electronic device", "slidable electronic device", "stretchable electronic device" and/or "rollable electronic device" may refer to an electronic device in which a display (e.g., the display 201 of FIG. 2A, the display module 410 of FIG. 4) is capable of bending deformation, such that at least a portion thereof is folded, wound or rolled, an area of at least a portion thereof is expanded, and/or the display may be housed inside a housing (e.g., the housing 210 of FIG. 2A, the housing 510 of FIG. 5A). The foldable electronic device, the slidable electronic device, the stretchable electronic device and/or the rollable electronic device may be used by expanding a screen display area by unfolding the display or exposing a wider area of the display to the outside according to the needs of the user.

According to an embodiment of the disclosure, an electronic device 300 (e.g., the electronic device 101 of FIG. 1, the electronic device 200 of FIG. 2A) may include a window layer 411 that is at least partially transparent; a display module 410 (e.g., the display module 160 of FIG. 1, the display 201 of FIG. 2A, and/or the display 330 of FIG. 3) disposed under the window layer; a housing 510 (e.g., the housing 210 of FIG. 2A) including a front surface in which the display module is disposed, a rear surface opposite to the front surface, and a side surface enclosing a space between the front surface and the rear surface; a frame 520 (e.g., the side bezel structure 218 of FIG. 2A or the lateral member 310 of FIG. 3) enclosing the side surface of the housing and a side surface 411c of the window layer; a first conduit 530 formed in at least one of one surface of the frame facing the housing or the side surface of the housing facing the frame and extended from a rear surface toward a front surface of the electronic device; and an adhesive material 610 introduced into the first conduit to adhere the side surface of the window layer to the housing and the frame.

Further, the first conduit may be formed at one surface of the frame facing the housing.

Further, the frame may include a second conduit 540 formed in the frame along a longitudinal direction to face at least a portion of the side surface of the window layer and connected to the first conduit, and the adhesive material may be introduced into the second conduit through the first conduit to be adhered to the side surface of the window layer.

Further, the first conduit may include a first hole 531 formed at the rear surface of the frame and a second hole 532 formed at the front surface of the frame.

Further, a width L2 of the second hole may be wider than a width L1 of the first hole.

Further, the first conduit may be formed at one surface of the housing facing the frame.

Further, the housing may include a second conduit 540 formed in the housing along a longitudinal direction and connected to the first conduit, and the adhesive material may be introduced into the second conduit through the first conduit to be adhered to the side surface of the window layer.

Further, the first conduit may include a first hole 531 formed at the rear surface of the housing and a second hole 532 formed at the front surface of the housing.

Further, a width L2 of the second hole may be wider than a width L1 of the first hole.

Further, the housing may include a protrusion 512 protruded toward the frame at one side surface facing the frame, and the frame may include a groove 523 into which the protrusion of the housing is inserted.

Further, the protrusion of the housing may include a hook formed in a bent shape at the end, and the groove of the frame may include a fastening portion to which the hook of the protrusion is fastened.

Further, the frame may include a side surface portion 521 extended toward the display module from one surface facing the housing, and the adhesive material may be disposed between the side surface portion and the side surface of the window layer.

Further, the display module may overlap at least partially with the side surface portion of the frame when viewed from a vertical direction.

Further, the display module may not overlap at least partially with the side surface portion of the frame when viewed from a vertical direction.

Further, the electronic device may further include an adhesive member disposed between the frame and the housing.

Further, the first conduit may be positioned at a corner of the electronic device.

Further, the housing may include a partition 511 enclosing the display module, and the adhesive material may be adhered to the partition of the housing and the side surface of the window layer.

According to an embodiment of the disclosure, an adhesive structure of a display module 410 (e.g., the display module 160 of FIG. 1, the display 201 of FIG. 2A, the display 330 of FIG. 3) including a window layer 411 may include a housing 510 (e.g., the housing 210 of FIG. 2A) including a front surface in which the display module is disposed, a rear surface opposite to the front surface, and a side surface enclosing a space between the front surface and the rear surface; a frame 520 (e.g., the side bezel structure 218 of FIG. 2A or the lateral member 310 of FIG. 3) enclosing the side surface of the housing and the side surface 411c of the window layer; a first conduit 530 formed in at least one of one surface of the frame facing the housing or the side surface of the housing facing the frame and extended from the rear surface toward the front surface of the housing; a second conduit 540 formed in at least one of one surface of the frame facing the housing or the side surface of the housing facing the frame and extended to enclose the display module and connected to the first conduit; and an adhesive material 610 introduced into the second conduit through the first conduit to adhere the side surface of the window layer to the housing and the frame.

Further, the frame may include a side surface portion 521 extended toward the display module from one surface facing the housing, and the adhesive material may be disposed between the side surface portion and the side surface of the window layer.

Further, the housing may include a protrusion 512 protruded toward the frame at one side surface facing the frame, and the frame may include a groove 523 into which the protrusion of the housing is inserted.

According to an embodiment of the disclosure, the display module 410 may be fixed to the housing 510 and the frame 520 through an adhesive material 610. In an embodiment, the adhesive material 610 may be disposed at the side surface 411c of the window layer 411 of the display module 410. In this case, an adhesive material may not be disposed under an edge of the display module 410, and a separate mounting portion for disposing the adhesive material may not be formed at the edge of the housing. Accordingly, an area of a bezel for covering the adhesive material and the mounting portion of the housing may be reduced. Accordingly, an area in which an image is displayed may be increased in a limited size of the display module 410.

## Claims

1. An electronic device 101, 200, or 300, comprising:
a window layer 411 that is at least partially transparent;
a display module 160, 201, 330, or 410 disposed under the window layer;
a housing 210 or 510 including a front surface in which the display module is disposed, a rear surface opposite to the front surface, and a side surface configured to enclose a space between the front surface and the rear surface;
a frame 218, 310, or 520 configured to enclose the side surface of the housing and a side surface of the window layer 411c;
a first conduit 530 formed in at least one of one surface of the frame facing the housing or the side surface of the housing facing the frame and extended from a rear surface to a front surface of the electronic device; and
an adhesive material 610 introduced into the first conduit to adhere the side surface of the window layer to the housing and the frame.

2. The electronic device of claim 1, wherein the first conduit is formed at one surface of the frame facing the housing,
the frame comprises a second conduit 540 formed in the frame along a longitudinal direction and having at least a portion facing a portion of the side surface of the window layer and connected to the first conduit, and
the adhesive material is introduced into the second conduit through the first conduit to be adhered to the side surface of the window layer.

3. The electronic device of claim 2, wherein the first conduit comprises a first hole 531 formed at a rear surface of the frame and a second hole 532 formed at a front surface of the frame.

4. The electronic device of claim 3, wherein a width L2 of the second hole is wider than a width L1 of the first hole.

5. The electronic device of claim 1, wherein the first conduit is formed at one surface of the housing facing the frame,
the housing comprises a second conduit 540 formed in the housing along a longitudinal direction and connected to the first conduit, and
the adhesive material is introduced into the second conduit through the first conduit to be adhered to the side surface of the window layer.

6. The electronic device of claim 5, wherein the first conduit comprises a first hole 531 formed at the rear surface of the housing and a second hole 532 formed at the front surface of the housing.

7. The electronic device of claim 6, wherein a width L2 of the second hole is wider than a width L1 of the first hole.

8. The electronic device of claim 1, wherein the housing comprises a protrusion 512 protruded toward the frame at one side surface facing the frame, and
the frame comprises a groove 523 into which the protrusion of the housing is inserted.

9. The electronic device of claim 8, wherein the protrusion of the housing comprises a hook formed in a bent shape at the end, and
the groove of the frame comprises a fastening portion to which the hook of the protrusion is fastened.

10. The electronic device of claim 1, wherein the frame comprises a side surface portion 521 extended toward the display module from one surface facing the housing, and
the adhesive material is disposed between the side surface portion and the side surface of the window layer.

11. The electronic device of claim 10, wherein the display module is configured to overlap at least partially with the side surface portion of the frame when viewed from a vertical direction.

12. The electronic device of claim 10, wherein the display module is configured to not overlap at least partially with the side surface portion of the frame when viewed from a vertical direction.

13. The electronic device of claim 1, further comprising an adhesive member disposed between the frame and the housing.

14. The electronic device of claim 1, wherein the first conduit is positioned at a corner of the electronic device.

15. The electronic device of claim 1, wherein the housing comprises a partition 511 configured to enclose the display module, and
the adhesive material is adhered to the partition of the housing and the side surface of the window layer.
